# EUROPEAN PATENT APPLICATION

(11) **EP 4 531 161 A1**
(43) Date of publication of application: **02.04.2025**
(21) Application number: 23200064.6
(22) Date of filing: 27.09.2023
(51) Int. Cl.: H01M 10/42, H01M 10/48, G01R 31/36

(54) **BATTERY TRACKING SYSTEM**

(71) Applicant: Murata Manufacturing Co., Ltd., Nagaokakyo-shi, Kyoto 617-8555 (JP)
(72) Inventor: HOSHIKUMA, Takahide, 81541 Munich (DE); KEZUKA, Koichiro, 81541 Munich (DE)
(74) Representative: Yoshida, Senko

(57) **Abstract**

A battery tracking system 1 comprising: a battery 2 comprising a control unit 10 configured to monitor a condition of the detached battery when the battery 2 has been detached from a device and transmit a signal including identification information of the detached battery 2, an external device 4 configured to receive the signal transmitted from the detached battery 2 and transmit location information of the external device together with the received signal, and a controller 6 configured to receive the location information and the signal transmitted from the external device 4 and determine a location of the detached battery 2 based on the received location information and signal.

## Description

### Technical Filed

Embodiments of the present disclosure relate to a battery tracking system, a battery tracking method and computer program to perform the battery tracking method.

### Back ground of the invention

In July 2023, the council of the EU adapted new regulation that strengths sustainability rules for batteries and waste batteries. The regulation will regulate the entire life cycle of batteries - from production to reuse and recycling - and ensure that they are safe, sustainable, and competitive. This regulation will apply to all batteries including all waste portable batteries, electric vehicle batteries, industrial batteries, starting, lighting and ignition (SLI) batteries and batteries for light means of transport.

Therefore, the present disclosure is concerned with a battery, e.g., a lithium ion battery, battery pack, battery cells, to which the battery regulation will be applied. According to the battery regulation, targets for producers to collect waste portable batteries will be set. Further, in the battery regulation, it will be set a battery passport for recording from purchasing material to recycle related battery life cycle based on QR-code, which is simple and cost effective. However, it is passive tracking, guess that QR-code cannot cover every tracking condition, e.g., in particular a case used by consumers.

In the current situation, there is no official statistics of recollection ratio of the waste batteries, however, it is assumed that the recollection ratio of portable batteries used by consumers is relatively low. Therefore, it is expected to improve the recollection ratio of the waste battery. For improvement the recollection ratio, it is necessary to correctly comprehend the battery condition and the battery location.

For monitoring the battery condition, a battery management system is known for monitoring the battery condition, for example, as disclosed in JP 2021 86816 A and US 11 698 415 B1. In addition, EP 4 060 598 A1 discloses an information system having a function to handle information about locations of batteries or battery mounted devices by using the GPS.

However, when the battery is mounted on the device, it is not necessary to know the battery location for recollecting the battery, since the battery is not the waste battery. In addition, the waste battery is usually not mounted on the device, and, therefore, it is not possible to determine the location of battery detached from the device by the above indicated known technology.

Thus, it is an object of the present invention to provide a battery tracking system which is possible to determine the battery location detached from the device, and, to accurately determine the battery condition whether the battery is waste battery or not to improve the recollection ratio of the waste battery.

### Summary of the invention

An embodiment according to the present application provides a battery tracking system comprising: a battery, e.g., lithium-ion battery, Pb-Acid battery, Ni-Cd battery, Ni-MH battery, Li-secondary battery, NaS battery and all-solid-state secondary battery, etc., comprising a control unit, e.g., a unit including a BMS (battery management system including a plurality of sensors for monitoring condition of the battery), a CMS(cell monitoring system) and signal/beacon generator, configured to monitor a condition of the battery, e.g., a voltage which is equal or less than a voltage to activate a device, when the battery has been detached from a device, e.g., mobile devices: portable cleaner, portable video game machine, laptop computer, OPE (outdoor power equipment) tool, etc., and transmit a signal including identification information of the detached battery, e.g., beacon with ID and battery status information, at least one external device, i.e., predetermined receiver, e.g., OPE (outdoor power equipment) tool, a battery charger, a mobile phone, a laptop computer, a base station, etc., configured to receive the signal transmitted from the detached battery, and transmit location information of the external device, e.g., ID of the external device associated with user information (address where the external device is located) of the external device, together with the received signal, a controller configured to receive the location information and the signal transmitted from the external device, and determine a location of the detached battery based on the received location information and signal, e.g., the location of the detached battery in relation with the external device based on the signal strength and chronicle record of the received signals. By receiving the signal transmitted from the battery via the external device at the controller, it is possible to determine a location of the detached battery without using the GPS, i.e., the location of the detached battery is determined based on the location information and the received signal character, and, therefore, it is possible to determine the location of the detached battery even if the battery is located somewhere indoors. As a result, it is possible to improve recollection ratio of the waste batteries, and by monitoring a condition of the detached battery, it is possible to appropriately warn occurrence of accidents caused by the waste battery, e.g., heat from the battery.

According to an embodiment of the present application, the control unit is configured to periodically, e.g., every minute, every hour, every day, every week, etc., transmit the signal during a predetermined period, e.g., 6 months, a year, several years, and wherein the controller is configured to store the received signal in chronicle order, and detect characteristics changes of the received signals, e.g., changes of signal strength. The periodical transmitted signals from the battery may be stored at the external device and transmitted to the controller in a predetermined interval. Based on the chronically stored signal, it is possible to determine whether the location of the detached battery has been changed, i.e., in case the detached battery has located in the same place longer than the predetermined period, the detached battery is assumed as a waste battery. Hence, it is possible to track the detached battery and to improve the recollection ratio of the waste battery.

According to an embodiment of the present application, the control unit is configured to determine whether a remaining voltage of the detached battery is equal or less than a predetermined voltage, and the predetermined voltage includes a first predetermined voltage, e.g., cut-off voltage (the voltage which a device cannot use, but chargeable, or the voltage at which a battery is considered fully discharged, beyond which further discharge could cause harm), and a second predetermined voltage, e.g., non-rechargeable voltage (the voltage which prohibits recharge of the battery, one of the eternal failed mode), which is less than the first predetermined voltage, when the remaining voltage of the detached battery is equal or less than the first predetermined voltage, the control unit is configured to transmit the signal. Further, the control unit is configured to disable the detached battery, when the remaining voltage of the detached battery is equal or less than the second predetermined voltage. That is, when the battery accidentally detached from the device, e.g., due to impact of clash or falling of the device, and the battery has the voltage to be used by the device, the signal is not transmitted from the battery. Further, for transmitting the signal, it can be used energy under the cut-off voltage, and, therefore, it is not necessary to provide extra power source for transmitting the signal from the detached battery. In addition, in case the voltage of the battery is non-rechargeable voltage, the battery is disabled, and, therefore, it is possible to avoid an accident cause of over-discharge of the battery.

According to an embodiment of the present application, the signal further includes information indicating a condition of the detached battery, and the controller is configured to determine whether the location of the detached battery has been changed based on the stored signals, when the location of the detached battery has not been changed more than predetermined period, and the condition of the detached battery indicates that the remaining voltage of the detached battery is equal or less than the second predetermined voltage, the controller is configured to transmit a notice including the location of the detached battery to a predetermined account, i.e., pre-registered account, e.g., a user, a seller and manufacture of the device and/or the battery.

According to an embodiment of the present application, wherein the battery tracking system comprises at least two or three external devices, which are located different position in relation with the detached battery. The number of the external device is dependent on utilized communication technology, e.g., RFID (radio-frequency identification), NFC (near-field communication), LoRa, BLE, and any other wireless communication technology, and the type of the external device. For example, in case of the external device is a portable device, e.g., a smart phone, the position of the portable device in relation with the detached battery is changed, and, the signal strength is changed in connection with the distance from the battery to the portable device. Thus, it is possible to determine the location of the detached battery based on the changes of the signal strength, and, hence, a single external device is required.

According to an embodiment of the present application, the control unit is configured to detect abnormality of the detached battery, e.g., temperature, humidity of the battery environment, abnormal gas, and to disable the detached battery when the abnormality of the detached battery is detected. The battery in the abnormal condition is disabled, and, therefore, it is possible to reduce the occurrence of the accident cause of the battery condition.

According to an embodiment of the present application, the signal further includes information indicating a condition of the detached battery, and wherein the controller is configured to transmit a notice including the location of the detached battery to a predetermined account, when the condition indicates the disability of the detached battery.

In case the battery is disabled, then, the location and the condition of the battery is informed to the predetermined account, e.g., the manufacture of the device, and/or the seller of the device, and, therefore it is possible to improve recollection ratio of the waste battery.

According to an embodiment of the present application, a battery tracking method comprising: receiving a location information of at least one external device and a signal including identification information of a battery detached from a device, wherein the signal is provided from the detached battery to the external device via the external device, and determining a location of the detached battery based on the received location information and signal. That is, the location of the detached battery is determined by the signal transmitted from the battery, and, therefore, it is possible to track the battery without using the GPS.

### Brief Description of the Figures

Embodiments according to the invention will subsequently be described taking reference to the enclosed figures in which:
- Fig. 1: shows a schematic diagram of a battery tracking system according to an embodiment of the present invention,
- Fig. 2: shows a schematic diagram of a control unit of the battery according to the embodiment of the present invention,
- Fig. 3: shows a schematic diagram of voltage per a cell,
- Fig. 4: shows a schematic diagram of a battery tracking system according to a variation of the embodiment of the present invention,
- Fig. 5: shows a schematic diagram of a battery tracking system according to a further variation of the embodiment of the present invention,
- Fig. 6: shows a schematic flowchart of a battery tracking method according to an embodiment of the present invention, and
- Fig. 7.: shows a schematic flowchart of a battery tracking method according to a variation of the embodiment of the present invention.

### Detailed Description of the Embodiments

Equal or equivalent elements or elements with equal or equivalent functionality are denoted in the following description by equal or equivalent reference numerals.

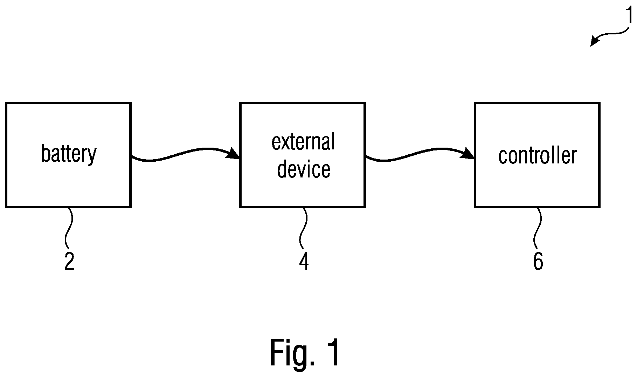

Fig. 1 shows a schematic diagram of a battery tracking system according to an embodiment of the present invention. The battery tracking system 1 comprises a battery 2 detached from a device, an external device 4 and a controller 6.

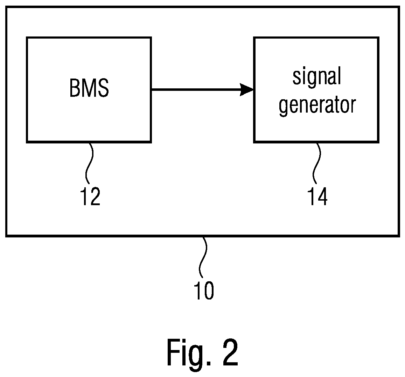

The battery 2 is a secondary battery and used in many products (devices), for example, such as electronics, portable video game machines, toys, portable cleaner, wireless headphones, handheld power tools, personal computers, small and large appliances, electric vehicles, and electrical energy storage systems. The battery 2 comprises a single cell and/or plurality of cells in series and/or parallel and a control unit 10. As shown in Fig. 2, the control unit 10 includes a battery management system 12 (BMS 12) including a plurality of sensors for monitoring conditions (e.g., voltage, temperature, current, health of individual cells, state of valance of cells, etc., not shown in Fig. 2) of the battery 2 and a signal (beacon) generator 14. The BMS 12 is any electronic system used for managing a rechargeable battery (cell or battery pack), such as by protecting the battery from operating outside its safe operating area, monitoring its state, calculating secondary data, reporting that data, controlling its environment, authenticating it and / or balancing it. The signal generator 14 generates a signal (beacon) and transmits the generated signal to the external device 4 via the BMS 12, when the battery is detached from a device at which the battery has been used as a power source. The signal generator 14 may be included in the BMS 12, and/or controlled by the BMS 12. The generated signal is transmitted together with the identification information of the battery 2, e.g., production number of the battery, or serial number of the battery 2, etc., and information indicating condition and status of the battery 2 to the external device 4.

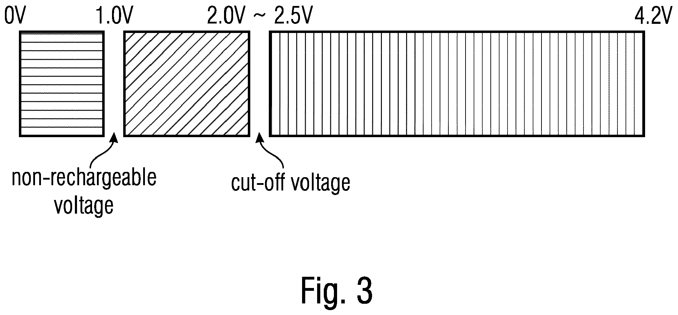

Fig. 3 shows a schematic diagram of voltage per a cell. It is well-known that the voltage of the battery could not fully used as a power source for the device. As shown in Fig. 3, there is a cut-off voltage which is set up around 2.0 to 2.5 V (the value of the cut-off voltage could be changed depending on the discharge ratio, cathode/anode material and the device), and a non-rechargeable voltage (eternal harm voltage) limit is set up around 1.0 V (the value of the non-rechargeable voltage could be changed depending on the discharge ratio, cathode/anode material and the device) per cell. That is, a full voltage to the cut-off voltage, e.g., 4.2 to 2.0 (2.5) V, is a voltage which a device can use, and the device cannot use the cut-off voltage. The BMS 12 monitors the voltage of the battery, and, when the voltage of the battery is equal or less than the cut-off voltage (the first predetermined voltage), the BMS 12 controls the signal generator to generate and transmit the signal to the external device 4 by using the cut-off voltage. That is, for generating and transmitting the signal, the cut-off voltage is used and, therefore, it is possible to transmit the signals from the battery to the external device even if the battery is indicating empty as a power source for the device.

The signal is transmitted from the battery 2 to the external device periodically, for example, every 30 seconds, every minute, every 5 minutes, or every hour, during a predetermined period, e.g., six months or until the voltage is reached to the non-rechargeable voltage (the second predetermined voltage). In case the voltage of the battery is equal or less than the non-rechargeable voltage, then, the BMS 12 disables the battery 2 and, determines the condition and status of the battery 2 as disabled and waste battery. Further, when the any abnormality of the battery 2 is determined by the BMS 12, the battery 2 is also disabled by the BMS 12.

The external device 4 is, for example, a charger of the battery, a mobile phone, a base station, the device from which the battery 2 has been detached, or any other device, and located at where device from which the battery has been detached is used and/or the user of the device is accommodated, e.g., user's house, user's working place, specific retail shop, and etc. The detached battery includes a battery physically detached from the device, and a battery which is physically attached to the device, however, the device is broken and it is not possible to use a battery tracking function of the device. In case the external device is a non-portable (immobile) device, e.g., a charger, a RFID (Radio Frequency Identification), a Bluetooth Low Energy (BLE), Wi-Fi, Bluetooth and/or an NFC (Near-field Communication) receiver is installed into the external device, and, the RFID tag or an NFC tag is installed into the battery 2. When the external device is a portable device, e.g., the mobile phone, then, the RFID or other wireless communication technology could be utilized, for example, Bluetooth Low Energy (BLE). The signal transmitted from the battery 2 is received by the external device 4, and, the external device 4 transmits the received signal together with the information indicating the location (location information) of the external device 4 to the controller 6. The external device 4 may store the received signals in chronicle order, and, transmit the stored signals together with the location information of the external device 4 to the controller 6 in a predetermined interval, e.g., every day.

The data transmitted from the external device 4, e.g., the signal from the battery 2 and the location information of the external device 4, are received by the controller 6, e.g., a cloud, a computing device, a server, etc. The controller 6 determines the location of the detached battery 2 based on the received signal including the battery identification information, the condition and the status of the detached battery, and the location information of the external device 4. For example, when the RFID is used for transmitting the signal from the battery 2 to the external device 4, and the signal from the battery is received by the external device 4, the battery is located within dedicated distance of the RFID, e.g., within 7 m from the external device 4. In case of the NFC is used, the location of the detached battery is within dedicated distance of the NFC, e.g., 30 cm from the external device 4. Then, it is determined that the battery is located within the dedicated distance of the external device 4, e.g., the same room, the same house, etc. Therefore, it is possible to determine the location of the detached battery 2 in relation with the location of the external device 4.

After determining the location of the detached battery 2, the controller 6 continuously tracks the location of the battery 2 and monitors the condition of the battery 2 based on the received data, i.e., the battery 2 is monitored whether the location of the detached battery has been changed or not, and whether the battery has been disabled in the predetermined period, e.g., 6 months. When the location of the detached battery has not been changed at least during the predetermined period, and/or the battery is disabled, the controller 6 determines that the battery 2 is waste battery. Then, the controller 6 transmits a notice that the location of the detached battery and status to the predetermined account, e.g., a preregistered account (email address, mobile phone number, etc.) of user, seller, manufacture and/or collector (agent) of the battery and/or the device. That is, the notice indicating the location of the waste battery and recollection request/demand. In case the battery 2 has been already disabled before passing the predetermined period, e.g., 6 months, the controller 6 determines the battery is the waste battery and transmits the notice immediately.

In this embodiment, the battery location is determined based on the location of the external device, the communication technology (method) between the external device and the battery, and the signal transmitted from the battery using the cut-off voltage. Thus, even if the battery is located indoor, it is possible to determine the location of the detached battery, and, it is not necessary to provide extra power source to transmit the signal. Therefore, the battery tracking system according to the present application is easily implemented. Further, the location and status of the battery is noticed to the preregistered account, and, therefore, it is possible to improve the recollection ratio of the waste battery.

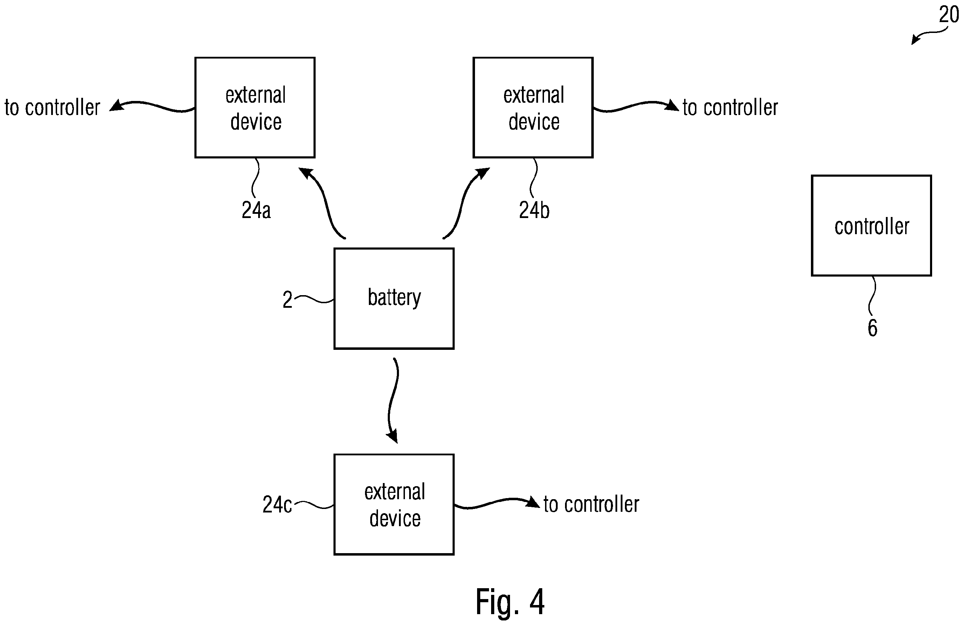

Fig. 4 shows a schematic diagram of a battery tracking system according to a variation of the embodiment of the present invention. The communication technology used for the embodiment represented by Fig. 4 is different from the embodiment represented by Fig.1, and there are some differences caused by the difference of the received signals. In the following, the different points from the embodiment represented by the Fig. 1 are explained.

As depicted in Fig. 4, the battery tracking system 20 comprises a plurality of external devices 24 a, 24b, 24c, and, LPWA (Low-Power Wide-Area Network), e.g., LoRa, is utilized for the communication between the battery 2 and the respective external devices 24a, 24b, 24c. For the communication between the battery 2 and the respective external devices 24a, 24b, 24c, other communication technology, e.g., cellular module, can be also used. Each external device 24a, 24b, 24c is located different location in relation with the location of the detached battery 2, e.g., the external device 24a is a charger and located at the place where the device (battery) is used, the external device 24b is located at one of the public facilities (station of the public transport, library, government office, city hall, etc.), and the external device 24c is located at the agent shop of the device and/or the battery. The signal transmitted from the battery 2 is received by the respective external devices 24a, 24b, 24c. The location of the respective external devices 24a, 24b, 24c is different in relation with the battery 2, i.e., the distance from the battery is different from each other, and, therefore, the signal strength of the received signals is also different from each other. The signals from the battery may be stored in the external device and transmitted to the controller, or transmitted via the external device to the controller without storing the external device. Then, the controller 6 determines the location of the detached battery based on the location of the external devices 24a, 24b, 24c, and the signal strength of the received signal at the respective external devices 24a, 24b, 24c. For example, based on the signal strength, it is possible to estimate the location range of the battery, e.g., the signal strength: strong, then, the battery 2 is located within 2 km from the external device 24a, the signal strength medium, then, the battery 2 is located within 5 km from the external device 24b, the signal strength: weak, then, the battery 2 is located within 8 km from the external device 24c. Then, the location of the detached battery is estimated by calculating a cross area of 2 km from the external device 24a, 5 km from the external device 24b, and 8 km from the external device 24c. After determining the location of the detached battery 2, the controller 6 implements further processes in the same way as the embodiment represented by Fig. 1.

According to the present embodiment, the battery tracking system comprises three external devices 24a, 24b, 24c, however, more than three external devices are also implemented, i.e., the more much number of the external devices improve the accuracy of the determined location of the detached battery. In addition, the location of the external devices is not limited to the above indicated examples.

It is noted that the required accuracy of the determined location of the detached battery is depending on the environment of the area where the battery could be located. For example, in the urban area, there are many buildings and/or houses in the small area, and, in the suburb area, there are less buildings and/or houses. Therefore, higher accuracy of the determined location of the detached battery is required in the urban area than the suburb area.

Further, the changes of the location of the detached battery are judged in tolerance of several meters to several ten meters, depending of the communication technology to be used and the environment of the area where the battery could be located. For example, when the location of the detached battery has been 3 m changed, it is not determined that the location of the battery has been changed. That is, when the location of the battery has been slightly changed, however, the location of the battery is still the same building or house (which could be determined by using a map of the area where the external devices are located), it is possible to recollect the waste battery. In other words, when the address of the location of the battery has not been changed, it is assumed that the battery has not been moved. Therefore, the small or slight changes of the location of the detached battery are not detected for determining the battery status, i.e., waste or not. The tolerance ratio of the movement may be preliminary determined.

In the present embodiment, LoRa and/or cellular module is utilized for communing between the battery and the respective external devices. The communication range of LoRa and/or cellular module is up to 10 to 15 km (depending on environment), and, therefore, it is possible to cover large area for tracking the battery. Hence, it is possible to efficiently recollect the waste battery, and the recollection ratio is improved.

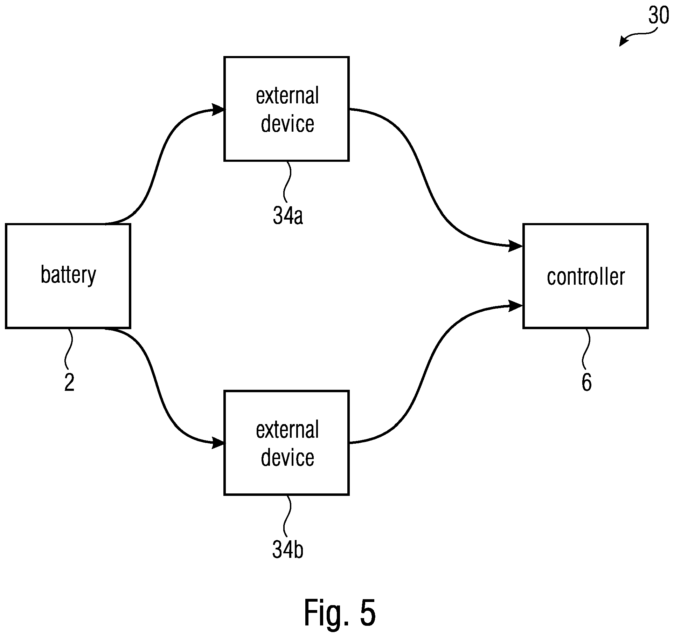

Fig. 5 shows a schematic diagram of a battery tracking system 30 according to a further variation of the embodiment of the present invention. The communication technology used for the embodiment represented by Fig. 5 is different from the embodiments represented by Fig. 1, and Fig. 4, and there are some differences caused by the difference of the condition of the received signals. In the following the difference points from the above indicated embodiments are explained.

As depicted in Fig. 5, the battery tracking system 30 comprises two external devices 34a and 34b, and BLE is utilized for the communication between the battery 2 and the external devices 34a and 34b. The external devices 34a and 34b are located different location in relation with the location of the detached battery 2, e.g., the external device 34a is a charger and located at the house (building) of the user of the battery (device), and the external device 34b is another device used by the user of the battery, for example, personal computer or smart phone.

The signal transmitted from the battery 2 is received by the respective external devices 34a and 34b. The location of the respective external devices 34a and 34b is different from each other in relation with the battery 2, i.e., the distance from the battery is different from each other, and, therefore, the signal strength of the received signals is also different from each other. The signals from the battery may be stored in the external device and transmitted to the controller, or transmitted via the external device to the controller. Then, the controller 6 determines the location of the detached battery based on the location of the external devices 34a and 34b, and the signal strength of the received signal at the respective external devices 34a and 34b.

In case one of the external devices 34a and 34b is a movable device, e.g., smart phone, then, the accuracy of determined the location of the detached battery is improved. That is, by changing the position of the smart phone, the signal strength of the received signal is also changed, and, therefore, by combining the movable and immovable external devices, it is possible to improve the accuracy of the determined location of the detached battery.

After determining the location of the detached battery, the controller 6 implements further processes in the same way as the embodiment represented by Fig. 1.

The communication range of the BLE is up to less than 100 m, and using at least two external devices to achieve two different characters of signals, e.g., different signal strength, and, therefore, it is possible to determine the location of the detached battery within a cross area of the dedicated distance from each of the external devices. In case one of the external devices is a mobile device, the signal strength of the received signal at the mobile device is changed every time when the mobile external device is moved, and, therefore, the accuracy of the determined location of the detached battery is improved.

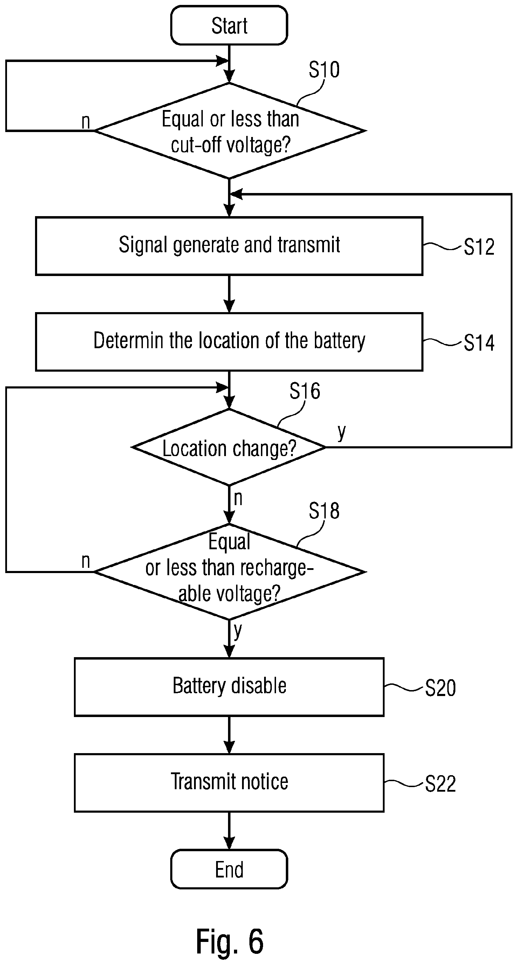

Fig. 6 shows a schematic flowchart of a battery tracking method according to an embodiment of the present invention.

As depicted in Fig. 6, when the battery is detached from the device, the remaining voltage of the battery is detected and determined whether the remining voltage of the battery is equal or less than the cut-off voltage (S10). When the remaining voltage of the battery is equal or less than the cut-off voltage, a signal (beacon) is generated at the detached battery and the generated signal is transmitted to one or more of the external devices together with identification information and information indicating conditions and status of the detached battery (S12). The signal and information are periodically transmitted from the battery to one or more of the external devices during the predetermined period. The detection process to detect the remaining voltage of the battery is continued until the remaining voltage is determined equal or less than the cut-off voltage.

The signal transmitted from the detached battery is received at one or more of the external devices, and one or more of the external devices transmits the received signal and the location information of the external device to the controller. The one or more of the external devices may chronically store the received signals and periodically transmit the stored signals together with the location information. The signal and information transmitted from the external device are received and chronically stored at the controller. Then, at the controller, the location of the detached battery is determined based on the stored signal and information, i.e., based on the signal character received by the external device, identification information of the battery, location information of the external device (S14). Then, it is determined whether the location of the detached battery has been changed (S16), i.e., based on the chronically stored data, the location of the detached battery is also chronically determined. Thus, from the chronically determined location of the detached battery, it is easily detected whether the location of the detached battery has been changed.

When the location of the detached battery has been changed (S16), the steps from S12 is repeated. When the location of the detached battery has not been changed (S16), the remaining voltage of the detached battery is checked whether the remaining voltage of the detached battery is equal or less than the rechargeable voltage (S18). That is, when the location of the detached battery has not been changed more than predetermined period, e.g., 6 months, the remaining voltage of the detached battery is checked based on the detached battery condition and status, i.e., the remaining voltage of the detached battery is monitored by the BMS of the battery, and, when the remaining voltage of the detached battery is equal or less than the rechargeable voltage (S18), the battery is disabled (S20) by the BMS. The information indicating the conditions and status of the battery is transmitted from the battery to the controller, and, therefore, when the controller receives the information indicating the remaining voltage of the battery is equal or less than the rechargeable voltage, and, the status of the battery is disable, then, the controller transmits a notice including the location of detached battery and existence of a waste battery to one or more of predetermined account (S22). The predetermined account is, for example, preregistered account of user of the battery (device), and the user may preliminarily register the permission for tracking the detached battery and receiving the notice regarding the waste battery. Further, the manufacture of the device where the battery is used as a power supply, or the agent of the device, or the seller of the device/battery may be preliminarily registered as the account.

It is not shown in Fig. 6, however, when the status of the battery indicates any abnormality, e.g., higher temperature of the detached battery, or any other failure detected by the BMS, then, the detached battery is disabled immediately to reduce a risk of accident. Then, the information indicating the condition and the status of the detached battery is transmitted to the controller together with the generated signals, and, therefore, after determining the location of the detached battery, the controller transmits the notice to the predetermined account without determining the location change of the detached battery.

According the embodiment represented by Fig. 6, the location of the detached battery is determined in case the remaining battery is equal or less than the cut-off voltage, and the battery generates and transmits the signal/beacon when the remaining voltage is equal or less than the cut-off voltage. Therefore, it is possible to track the location of the detached battery without providing any power source for tracking the detached battery. In addition, in case the abnormality is detected, the detached battery is disabled and the notice is transmitted to the predetermined account, and, therefore, it is possible to reduce the risk of accident cause by the detached battery.

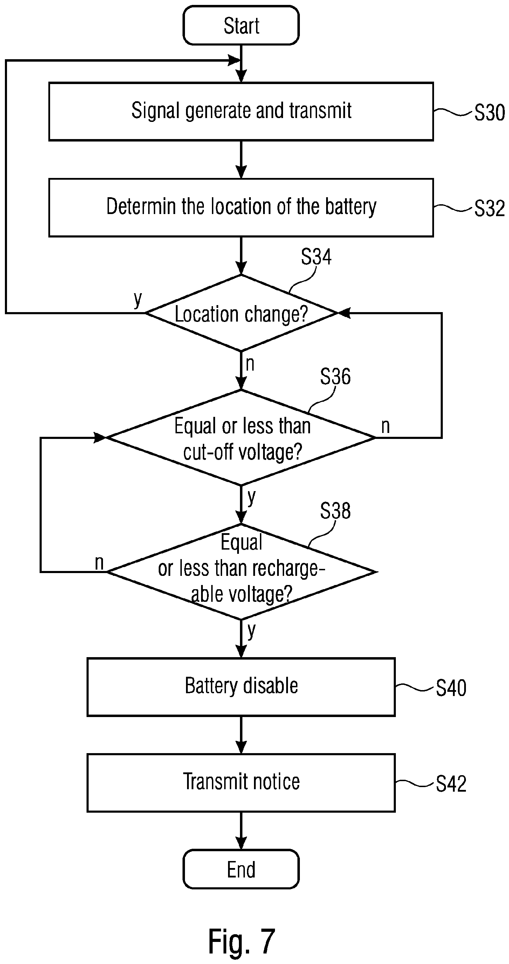

Alternatively, the battery may generate and transmit signal/beacon when the battery is detached from the device depicted as another embodiment in Fig. 7. In this embodiment, the order of the process is different from the embodiment represented by Fig. 6. That is, the battery tracking is started when the battery is detached from the device, i.e., without checking the remaining voltage of the detached battery. Other than the order of the process, the implementation of the embodiment represented by Fig. 7 is the same as the process of the embodiment represented by Fig. 6.

According to the above indicated embodiments, the detached battery located in the same place more than 6 months, and the battery is disabled, then, the location of the detached battery is noticed as the location of the waste battery. That is, in case the remaining voltage of the detached battery is more than the rechargeable voltage, it is still possible to use the battery for the device. Therefore, in case the location of the detached battery has not been changed more than 6 months, however, the remaining voltage is more than rechargeable voltage and there is no abnormality, the battery is not determined as the waste battery. In this case, if it is preliminarily registered to issue the notice of the unmoved detached battery to the account, then, the controller may issue the notice to indicated the location of the detached battery to the registered account.

According to the embodiments of the battery tracking method of the present invention, the location of the detached battery is tracked, and the condition and the status of the battery is monitored. Thus, it is possible to disable the battery which has any abnormality, and, hence, the risk of accidents is reduced. Further, the location of the detached battery is noticed to the predetermined account, e.g., user, seller, manufacture, etc., and, therefore, it is possible to improve recollection ratio of the waste battery.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A battery tracking system (1, 20, 30) comprising:
a battery (2) comprising a control unit (10) configured to
monitor a condition of the detached battery when the battery (2) has been detached from a device, and
transmit a signal including identification information of the detached battery (2),
at least one external device (4, 24a, 24b, 24c, 34a, 34b) configured to
receive the signal transmitted from the detached battery (2), and
transmit location information of the external device together with the received signal, a controller (6) configured to
receive the location information and the signal transmitted from the external device (4, 24a, 24b, 24c, 34a, 34b), and
determine a location of the detached battery (2) based on the received location information and signal.

2. The battery tracking system (1, 20, 30) according to claim 1,
wherein the control unit (10) is configured to periodically transmit the signal during a predetermined period, and
wherein the controller (6) is configured to store the received signal in chronicle order, and detect characteristics changes of the received signals.

3. The battery tracking system (1, 20, 30) according to claim 1,
wherein the control unit (10) is configured to periodically transmit the signal during a predetermined period, and
wherein the external device (4, 24a, 24b, 24c, 34a, 34b) is configured to store the received signal in chronicle order, and transmit the stored signals together with the location information in a predetermined interval.

4. The battery tracking system (1, 20, 30) according to any one of claims 1 to 3,
wherein the control unit (10) is configured to determine whether a remaining voltage of the detached battery (2) is equal or less than a predetermined voltage, and
wherein the predetermined voltage includes a first predetermined voltage and a second predetermined voltage which is less than the first predetermined voltage,
when the remaining voltage of the detached battery (2) is equal or less than the first predetermined voltage, the control unit (10) is configured to transmit the signal.

5. The battery tracking system (1, 20, 30) according to claim 4,
wherein the control unit (10) is configured to disable the detached battery (2), when the remaining voltage of the detached battery (2) is equal or less than the second predetermined voltage.

6. The battery tracking system (1, 20, 30) according to claim 5,
wherein the signal further includes information indicating a condition of the detached battery (2), and
wherein the controller (6) is configured to determine whether the location of the detached battery (2) has been changed based on the stored signals,
when the location of the detached battery (2) has not been changed more than predetermined period, and the condition of the detached battery (2) indicates that the remaining voltage of the detached battery is equal or less than the second predetermined voltage, the controller (6) is configured to transmit a notice including the location of the detached battery to a predetermined account.

7. The battery tracking system (20, 30) according to any one of claims 1 to 6,
wherein the battery tracking system comprises at least two external devices (24a, 24b, 24c, 34a, 34b), which are located different position in relation with the detached battery (2).

8. The battery tracking system (20) according to any one of claims 1 to 6,
wherein the battery tracking system (20) comprises more than three external devices (24a, 24b, 24c), and each external device (24a, 24b, 24c) is located different place in relation with the detached battery (2).

9. The battery tracking system (1, 30) according to any one of claims 2 to 6,
wherein the external device (4, 34a, 34b) is a single portable device,
wherein the controller (6) is configured to determine a location of the detached battery (2) based on the stored location information and signals.

10. The battery tracking system (1, 20, 30) according to any one of claims 1 to 9,
wherein the control unit (10) is configured to detect abnormality of the detached battery (2), and to disable the detached battery (2) when the abnormality of the detached battery (2) is detected.

11. The battery tracking system (1, 20, 30) according to claim 10,
wherein the signal further includes information indicating a condition of the detached battery (2), and
wherein the controller (6) is configured to transmit a notice including the location of the detached battery (2) and the condition of the detached battery (2) to a predetermined account, when the condition indicates the disability of the detached battery (2).

12. A battery tracking method comprising:
monitoring a condition of the detached battery when the battery (2) has been detached from a device,
transmitting a signal including identification information of the detached battery (2) to at least one external device (4, 24a, 24b, 24c, 34a, 34b),
receiving the signal transmitted from the detached battery (2) at the external device (4, 24a, 24b, 24c, 34a, 34b),
transmitting location information of the external device (4, 24a, 24b, 24c, 34a, 34b) together with the received signal to a controller (6),
receiving a location information of at least one external device (4, 24a, 24b, 24c, 34a, 34b) and a signal including identification information of a battery detached from a device at the controller (6), and
determining a location of the detached battery (2) based on the received location information and signal at the controller (6).

13. A battery tracking program for performing a method according to claim 12, when the computer program runs on a computer.
